# EUROPEAN PATENT SPECIFICATION

(11) **EP 3 001 176 B1**
(45) Date of publication and mention of the grant of the patent: **06.11.2019**
(21) Application number: 15186641.5
(22) Date of filing: 24.09.2015
(51) Int. Cl.: G01N 17/04, G01N 17/02

(54) **SENSOR FOR MONITORING CORROSION**
SENSOR ZUR KORROSIONSÜBERWACHUNG
CAPTEUR POUR LA SURVEILLANCE DE LA CORROSION

(30) Priority: 29.09.2014 KR 20140129880
(43) Date of publication of application: 30.03.2016
(73) Proprietor: Korea Electric Power Corporation, Jeollanam-do 58217 (KR)
(72) Inventor: Kim, Do-Hyung, 34049 Daejeon (KR); Soh, Joon-Young, 34053 Daejeon (KR); Kim, Kyong-Ok, 34053 Daejeon (KR)
(74) Representative: Sonnenberg, Fred

(56) References cited:
- US-A- 6 132 593
- LIETAI YANG ET AL: "COUPLED MULTIELECTRODE ARRAY SYSTEMS AND SENSORS FOR REAL-TIME CORROSION MONITORING - A REVIEW", CORROSION NACEXPO 2006, 2006, XP055246870,

## Description

### BACKGROUND

The present invention claims priority of Korean application 10-2014-0129880, filed on 29 september 2014.

The present inventive concept relates to a sensor for monitoring corrosion and more particularly, to a sensor for monitoring corrosion, able to measure deterioration in a coating film and a rate of consumption of a sacrificial anode, occurring in an underwater portion of an offshore structure below sea level, and a method of manufacturing the same.

In general, anticorrosion measures used on offshore structures such as offshore wind power generators are a surface coating scheme and an electric anticorrosion scheme. Since such offshore structures may be installed in relatively deep water, as compared to land-based structures or coastal structures, considerably high maintenance costs have been incurred in the use of such structures, due to limitations on factors such as ships, manpower, special equipment, working periods, and the like.

More specifically, for example, since offshore wind farms have significantly large and wide extents, visual inspection thereof using boats, ships and the like may be highly restricted, and the ability to undertake visual inspections of structures located below sea level, that is, in an underwater portion, is extremely limited.

In the underwater portion below sea level, such visual inspection may not be smoothly undertaken to lead to difficulties such as the necessity for diagnosing corrosion using divers or special equipment, thereby resulting in an increase in costs.

In order to reduce costs, a system for monitoring corrosion in underwater portions of structures is required and along with monitoring thereof, a diagnostic program is necessary to prevent the diffusion of corrosion.

Considering related-art techniques for monitoring corrosion, there are provided techniques for monitoring corrosion potential (please refer to Patent Documents EP 1693664, WO 2006/135391, US 6902661 and the like). The techniques are mostly applied to steel and are mainly configured of technologies for analyzing surface states of steel by measuring a corrosion potential thereof. To apply the techniques to coating films to be located underwater, below sea level, may be practically difficult because potential characteristics are varied depending on types of respective coating films.

Next, there are provided techniques for monitoring a corrosion rate (please refer to Patent Documents, US 6419817, KR 2014-0028958, and the like). In the techniques, an electrical resistance (ER) or linear polarization resistance (LPR) sensor is mainly used, and after applying a constant level of voltage or current to an electrode, consequent variations in the current may be measured to calculate a corrosion rate. The majority of the measurement methods have been used in the measurement of corrosion states of steel, rather than in analyzing the deterioration of coating films.

In addition, as other techniques for monitoring corrosion, there are provided electrochemical impedance measurement methods (please refer to Patent Documents, WO 2009/049125, US 2005-0212534, US 6911828, KR 2010-0105651, and the like). The measurement methods require devices such as a voltage input device, a frequency converter, a frequency analyzer, and the like, and thus, may be disadvantageous, in that an overall configuration thereof may be complicated and deterioration in coating films may be accelerated due to an AC voltage input thereto.

Finally, there are provided electrochemical noise measurement methods (please refer to Patent Documents, WO 2002/073169, US 6294074, US 5888374, US 6478948, and the like). The greatest features of the measurement methods are to analyze corrosion states by only processing voltage and current signals without an external input device.

However, considering the techniques for monitoring corrosion according to the related art, the techniques relate to methods of measuring corrosion states or corrosion rates of steel, rather than coating films.

Some of the electrochemical impedance measurement methods have suggested techniques for monitoring localized corrosion and deterioration of coating films; however, such electrochemical impedance measurement methods require external input devices and frequency analyzing devices as described above, thereby causing limitations such as the consumption of power and complexity in measurement devices. In addition, deterioration in the coating films may be relatively accelerated due to an AC voltage input from the outside.

In addition, the majority of the electrochemical noise measurement methods deal with sensors and signal processing methods that are restricted to localized corrosion occurring in boilers or atomic apparatuses, and have not yet been applied to the underwater portions of structures disposed below sea level. The paper by Lietai Yang et AL: "Coupled Multi-electrode Array systems and sensors for real-time corrosion monitoring - a review", in CORROSION NACEXPO 2006, describes a sensor for monitoring corrosion according to the preamble of claim 1.

### SUMMARY

An aspect of the present inventive concept may provide a sensor for monitoring corrosion according to claim 1, able to measure deterioration in a coating film and a rate of consumption of a sacrificial anode, occurring in an underwater portion of an offshore structure below sea level.

According to an aspect of the present inventive concept, the sensor for monitoring corrosion includes: a sensor case with a signal processing unit therein, and a probe unit installed on one side of an interior of the sensor case and simultaneously measuring deterioration in a coating film of a structure and a rate of consumption of a sacrificial anode of the structure.

Outside the scope of the present invention, a method of manufacturing of the sensor for monitoring corrosion is described hereafter, which may include: molding a probe unit simultaneously measuring deterioration in a coating film of a structure and a rate of consumption of a sacrificial anode of the structure; and coupling the probe unit completed to a sensor case.

### BRIEF DESCRIPTION OF DRAWINGS

The above and other aspects, features and advantages of the present inventive concept will be more clearly understood from the following detailed description taken in conjunction with the accompanying drawings, in which:
FIG. 1 is a perspective view illustrating a coating film probe of a sensor for monitoring corrosion according to an exemplary embodiment of the present inventive concept;
FIG. 2 is a perspective view illustrating a sacrificial anode probe of the sensor for monitoring corrosion according to an exemplary embodiment of the present inventive concept;
FIG. 3 is a plan view schematically illustrating a holder used in a method of manufacturing the sensor for monitoring corrosion according to an exemplary embodiment of the present inventive concept;
FIG. 4 is a view schematically illustrating a molding process in the method of manufacturing the sensor for monitoring corrosion according to an exemplary embodiment of the present inventive concept;
FIG. 5 is a front view illustrating a probe unit of the sensor for monitoring corrosion according to an exemplary embodiment of the present inventive concept;
FIG. 6 is a cross-sectional view, taken along line A-A' of FIG. 5;
FIG. 7 is a cross-sectional view, taken along line B-B' of FIG. 5;
FIG. 8 is a front view illustrating a sensor for monitoring corrosion according to an exemplary embodiment of the present inventive concept;
FIG. 9 is a cross-sectional view, taken along line C-C' of FIG. 8; and
FIG. 10 is a block diagram schematically illustrating a configuration of a signal processing unit of the sensor for monitoring corrosion according to an exemplary embodiment of the present inventive concept.

### DETAILED DESCRIPTION

Exemplary embodiments of the present inventive concept will now be described in detail with reference to the accompanying drawings.

The inventive concept may, however, be exemplified in many different forms and should not be construed as being limited to the specific embodiments set forth herein. Rather, these embodiments are provided so that this disclosure will be thorough and complete, and will fully convey the scope of the inventive concept to those skilled in the art.

In the drawings, the shapes and dimensions of elements may be exaggerated for clarity, and the same reference numerals will be used throughout to designate the same or like elements.

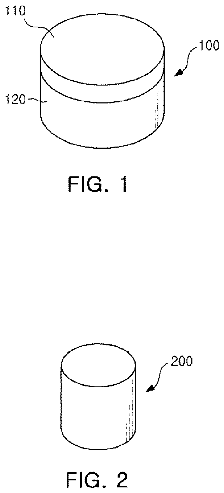

FIG. 1 is a perspective view illustrating a coating film probe of a sensor for monitoring corrosion according to an exemplary embodiment of the present inventive concept. A coating film probe 100 may be configured by processing a body portion 120 formed of a material the same as a material (for example, a steel or the like) constituting an offshore structure, in a tubular shape or a pillar shape, and forming a coating film portion 110 through coating a coating film used in the offshore structure on one surface of the body portion 120. The coating film probe 100 configured as above may indicate deterioration in the coating film of the offshore structure and at the same time, may determine a corrosion rate of the body portion 120 to calculate a residual corrosion tolerance thickness at the time of the termination of deterioration of the coating film portion 110.

FIG. 2 is a perspective view illustrating a sacrificial anode probe of the sensor for monitoring corrosion according to an exemplary embodiment of the present inventive concept. Below sea level, a sacrificial anode is typically formed of aluminum, an aluminum-zinc alloy, magnesium or the like. Thus, a sacrificial anode probe 200 may be manufactured by processing a material the same as that used as a sacrificial anode in an undersea portion of an offshore structure, in a tubular shape or a pillar shape.

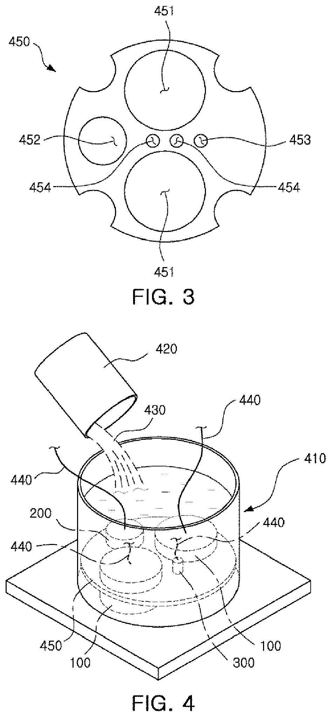

Although not separately illustrated, a reference electrode 300 (Please refer to FIG. 4, FIG. 5, FIG. 7, and FIG. 8) for providing a reference potential in measuring potentials is provided. The reference electrode 300 may be formed of, for example, silver (Ag), platinum (Pt) or the like.

FIG. 4 is a view schematically illustrating a molding process for manufacturing the sensor for monitoring corrosion according to an exemplary embodiment of the present inventive concept. As illustrated in FIG. 4, the coating film probe 100, the sacrificial anode probe 200, and the reference electrode 300, separately manufactured, are fixed to a mold 410, and a molding resin 430 prepared in a resin-mixing bath 420 may be injected into the mold 410 to mold a probe unit. In this case, signal lead wires 440 may be molded to protrude outwardly from the probe unit, thereby allowing the application of power or the transmission of a signal to be smoothly performed.

As the resin, a material having a significantly low shrinkage rate at the time of solidification in order to minimize corrosion or the like, in a gap of an edge portion, as well as having superior waterproofing properties and chemical-resistance properties and a high degree of resistance to the infiltration of seawater, may be selected. For example, an acrylic resin or an epoxy resin may be selected.

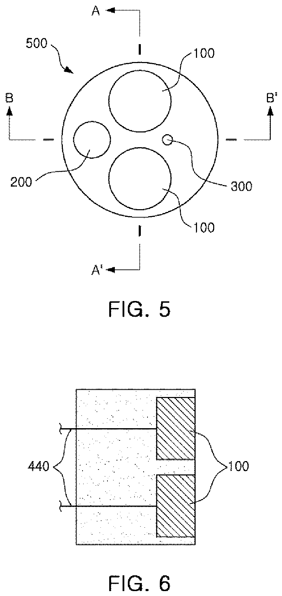

When the resin is cured, it may be drawn out of the mold 410, thereby obtaining a probe unit 500 having the coating film probe 100, the sacrificial anode probe 200, and the reference electrode 300 integrated with one another, as illustrated in FIG. 5.

Meanwhile, during the molding process, a holder for fixing the coating film probe 100, the sacrificial anode probe 200, and the reference electrode 300 may be used. FIG. 3 is a plan view schematically illustrating a holder used in a method of manufacturing the sensor for monitoring corrosion according to an exemplary embodiment of the present inventive concept.

As illustrated in the exemplary embodiment, a holder 450 may be provided with a coating film probe opening 451 for the coating film probe 100, a sacrificial anode probe opening 452 for the sacrificial anode probe 200, and a reference electrode opening 453 for the reference electrode 300. The openings may serve to fix the coating film probe 100, the sacrificial anode probe 200, and the reference electrode 300 at regular intervals during molding.

Through holes 454 formed in a central portion of the holder 450 may allow gas bubbles or the like to be easily expelled from the resin during molding. In addition, the holder 450 may have a size or a shape to form a gap or space between the mold 410 and the holder 450 in order to facilitate the injection of resin during molding. The holder 450 may be formed of a material having no electrical conductivity and for example, may preferably be formed of a highly chemical-resistant material such as fluorine plastics.

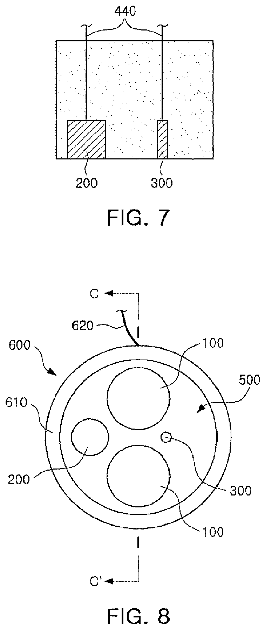

FIG. 5 is a front view illustrating a probe unit of the sensor for monitoring corrosion according to an exemplary embodiment of the present inventive concept. FIG. 6 is a cross-sectional view, taken along line A-A' of FIG. 5. FIG. 7 is a cross-sectional view, taken along line B-B' of FIG. 5. As illustrated in the drawings, the sensor for monitoring corrosion according to the present inventive concept includes the probe unit 500 formed by integrally molding at least one coating film probe 100 having the coating film portion 110 formed through coating a coating film used in a structure (not shown); at least one sacrificial anode probe 200 formed of a material the same as that of a sacrificial anode of the structure; and the reference electrode 300 for providing a reference potential.

The signal lead wires 440 are respectively connected to the individual coating film probe 100, sacrificial anode probe 200 and reference electrode 300, and may protrude outwardly from the probe unit 500 as described above, thereby allowing the application of power or the transmission of a signal to be smoothly performed.

In addition, one surfaces of the coating film probe 100, the sacrificial anode probe 200, and the reference electrode 300 may be configured to be exposed from the probe unit 500, such that a surface area of the probe may be accurately calculated, in measuring deterioration of the coating film and a rate of consumption of the sacrificial anode.

Although FIG. 3 through FIG. 9 illustrate an example of the probe unit 500 including a pair of coating film probes 100, a single sacrificial anode probe 200, and a single reference electrode 300, the number of the probes 100 and 200 are not limited thereto and if necessary, may be further increased within a single probe unit 500.

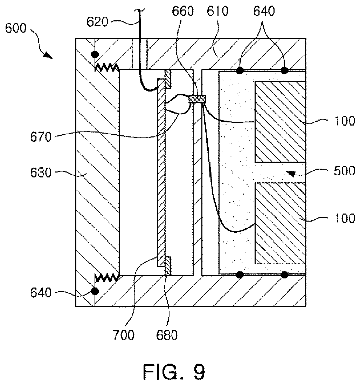

FIG. 8 is a front view illustrating a sensor for monitoring corrosion according to an exemplary embodiment of the present inventive concept. FIG. 9 is a cross-sectional view, taken along line C-C' of FIG. 8. As illustrated in the drawings, a sensor 600 for monitoring corrosion according to an exemplary embodiment of the present inventive concept may include the probe unit 500, a sensor case 610, a communications line 620, and a signal processing unit 700.

The sensor case 610 may be provided to protect the probe unit 500, signal lead wires 440 and 670, the signal processing unit 700 and the like, from the seawater. The sensor case 610 may be a member formed in a substantially tubular or pipe shape, using a material such as fiber reinforced plastics (FRP), fluorine plastics or the like.

When the probe unit 500 is completed and prepared, the probe unit 500 may be coupled to an opening of the sensor case 610 and in this case, a space between the probe unit 500 and the sensor case 610 may be water-tightly sealed using a sealing member 640, such as an O-ring, thereby preventing the infiltration of seawater.

The signal lead wire 440 of the probe unit 500 may be connected to a cable connector 660 and the signal lead wire 670 drawn-out from the cable connector 660 may be connected to the signal processing unit 700. However, the cable connector may be omitted or may be replaced with another electrical connection means.

Accordingly, the probe unit 500 may be electrically connected to the signal processing unit 700 via the signal lead wire or the cable connector, and a signal having been processed by the signal processing unit may deliver information relating to corrosion in an offshore structure via the communications line 620.

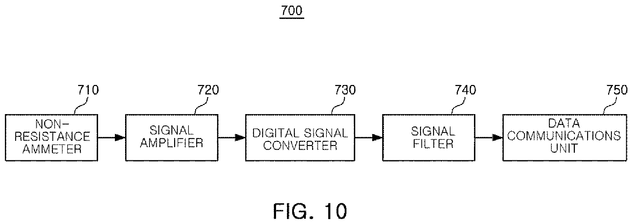

FIG. 10 is a block diagram schematically illustrating a configuration of a signal processing unit of the sensor for monitoring corrosion according to an exemplary embodiment of the present inventive concept. As illustrated in FIG. 10, the signal processing unit 700 includes a non-resistance ammeter 710 measuring a current or a voltage of the coating film probe 100, the sacrificial anode probe 200, or the reference electrode 300; a signal amplifier 720 amplifying a current or voltage signal input through the non-resistance ammeter 710; an analog to digital signal converter 730 converting the amplified signal into a digital signal; a signal filter 740 filtering the converted digital signal; and a data communications unit 750 transmitting the filtered signal to a user.

The signal processing unit 700 may be formed of, for example, a printed circuit board (PCB) and is embedded in the sensor 600 for monitoring corrosion, itself, so as to minimize the influence of noise, but is not limited thereto.

In addition, a plurality of signal processing units 700 may be provided, and example, one pair of the coating film probes 100 and the reference electrode 300 may be connected to one signal processing unit 700 to configure a first cell, while another pair of the coating film probes 100, the sacrificial anode probe 200, and the reference electrode 300 may be connected to another signal processing unit 700 to configure a second cell.

The signal processing unit 700 may be mounted on a fixing member 680 provided within the sensor case 610, using a fixing element such as a fixing screw, an adhesive or the like and may secure stability thereof under offshore environmental conditions.

Meanwhile, the sensor case 610 may be provided with a cover 630 for the maintenance of the signal processing unit 700. The cover 630 may be combined with the sensor case 610 in a screw-coupled manner, and it may also be preferable to use the sealing member 640 such as an O-ring in a space between the cover 630 and the sensor case 610 to prevent the infiltration of seawater.

Hereinafter, an operation of the sensor for monitoring corrosion according to an exemplary embodiment of the present inventive concept will briefly be described.

First, in the coating film probe 100 and the sacrificial anode probe 200 exposed to offshore environments, deterioration progresses in the coating film portion 110, and the sacrificial anode probe 200 is gradually consumed over time. Variations in voltage and current may be generated in the both probes. The variations in voltage and current over time may be input to the signal processing unit 700 through the signal lead wire 440, the cable connector 660, and the signal lead wire 670.

After current and voltage signals input to the signal processing unit 700 are processed by the signal processing unit 700, information regarding a rate of progress of deterioration in the coating film and a rate of consumption of the sacrificial anode may be provided to a user via the communications line 620.

As set forth above, according to exemplary embodiments of the present inventive concept, deterioration in a coating film and a rate of consumption of a sacrificial anode, occurring in an underwater portion of an offshore structure below sea level, for example, may be simultaneously measured, using a simply configured sensor for monitoring corrosion.

In addition, according to exemplary embodiments of the present inventive concept, a sensor for monitoring corrosion may be manufactured through a simple and inexpensive process.

## Claims

1. A sensor for monitoring corrosion, comprising:
a sensor case (610), and
a probe unit (500) installed on one side of an interior of the sensor case and simultaneously measuring deterioration in a coating film of a structure and a rate of consumption of a sacrificial anode of the structure, **characterized in that**
the sensor case (610) includes a signal processing unit (700) therein, and
the probe unit (500) is formed by integrally molding at least one coating film probe (100) having a coating film portion (110) formed through coating the coating film used in a structure; at least one sacrificial anode probe (200) formed of a material the same as that of the sacrificial anode of the structure; and a reference electrode (300) for providing a reference potential,
the probe unit is electrically connected to the signal processing unit, and
wherein the signal processing unit (700) includes:
a non-resistance ammeter (710) measuring a current or a voltage of the coating film probe, the sacrificial anode probe, or the reference electrode;
a signal amplifier (720) amplifying a current or voltage signal input through the non-resistance ammeter;
analog to digital signal converter (730) converting the amplified signal into a digital signal;
a signal filter (740) filtering the converted digital signal; and
a data communications unit (750) transmitting the filtered signal.

2. The sensor for monitoring corrosion of claim 1, wherein the coating film portion (110) of the coating film probe is formed on one surface of a body portion (120) formed of the same material as a material constituting the structure.

3. The sensor for monitoring corrosion of claim 1 or 2, wherein signal lead wires (440) are respectively connected to the coating film probe (100), sacrificial anode probe (200) and reference electrode (300).

4. The sensor for monitoring corrosion of claim 3, wherein
the signal lead wires are electrically connected to the signal processing unit.

5. The sensor for monitoring corrosion of claim 4, wherein the sensor case is provided with a cover (630) for maintenance of the signal processing unit.

## Patentansprüche

1. Sensor zum Überwachen von Korrosion, umfassend:
ein Sensorgehäuse (610) und
eine Untersuchungseinheit (500), die auf einer Seite eines Innenraums des Sensorgehäuses installiert ist und gleichzeitig die Verschlechterung in einem Beschichtungsfilm einer Struktur und eine Verbrauchsrate einer Opferanode der Struktur misst, **dadurch gekennzeichnet, dass** das Sensorgehäuse (610) eine Signalverarbeitungseinheit (700) darin beinhaltet, und die Untersuchungseinheit (500) gebildet ist durch integrales Formen mindestens einer Beschichtungsfilmprobe (100), aufweisend einen Beschichtungsfilmabschnitt (110), gebildet durch Beschichten des in einer Struktur verwendeten Beschichtungsfilms; mindestens eine Opferanoden-Probe (200), aus einem Material gebildet, das demjenigen der Opferanode der Struktur entspricht; und eine Referenzelektrode (300) zum Bereitstellen eines Referenzpotenzials, die Untersuchungseinheit elektrisch mit der Signalverarbeitungseinheit verbunden ist, und wobei die Signalverarbeitungseinheit (700) beinhaltet:
ein widerstandsloses Amperemeter (710), das einen Strom oder eine Spannung der Beschichtungsfilmprobe, der Opferanoden-Probe oder der Referenzelektrode misst;
einen Signalverstärker (720), der ein von dem widerstandslosen Amperemeter eingegebenes Strom- oder Spannungssignal verstärkt;
Analog-Digital-Signalwandler (730), das verstärkte Signal in ein digitales Signal umwandelnd;
einen Signalfilter (740), der das gewandelte digitale Signal filtert; und
eine Datenübertragungseinheit (750), die das gefilterte Signal sendet.

2. Sensor zum Überwachen von Korrosion nach Anspruch 1, bei welchem der Beschichtungsfilmabschnitt (110) auf einer Fläche eines Körperabschnitts (120) gebildet ist, aus dem gleichen Material wie ein die Struktur bildendes Material gebildet.

3. Sensor zum Überwachen von Korrosion nach Anspruch 1 oder 2, bei welchem Signalleitungsdrähte (440) jeweils mit der Beschichtungsfilmprobe (100), der Opferanoden-Probe (200) und der Referenzelektrode (300) verbunden sind.

4. Sensor zum Überwachen von Korrosion nach Anspruch 3, bei welchem die Signalleitungen elektrisch mit der Signalverarbeitungseinheit verbunden sind.

5. Sensor zum Überwachen von Korrosion nach Anspruch 4, bei welchem das Sensorgehäuse mit einer Abdeckung (630) zur Wartung der Signalverarbeitungseinheit versehen ist.

## Revendications

1. Capteur pour la surveillance de corrosion, comprenant :
un boîtier de capteur (610), et
une unité d'investigation (500) installée sur un côté d'un intérieur du boîtier de capteur et mesurant simultanément la détérioration d'un film de revêtement d'une structure et une vitesse de consommation d'une anode sacrificielle de la structure, **caractérisé en ce que**
le boîtier de capteur (610) comprend une unité de traitement de signal (700), dans celui-ci et
l'unité d'investigation (500) est formée en moulant intégralement au moins un échantillon de film de revêtement (100) ayant une partie de film de revêtement (110) formée par revêtement du film de revêtement utilisé dans une structure ; au moins un échantillon d'anode sacrificielle (200) formée d'un matériau identique à celui de l'anode sacrificielle de la structure ; et une électrode de référence (300) pour fournir un potentiel de référence,
l'unité d'investigation est connectée électriquement à l'unité de traitement de signal, et
dans lequel l'unité de traitement de signal (700) comprend :
un ampèremètre sans résistance (710) mesurant un courant ou une tension de l'échantillon de film de revêtement, de l'échantillon d'anode sacrificielle ou de l'électrode de référence ;
un amplificateur de signal (720) amplifiant un signal d'entrée de courant ou de tension à travers l'ampèremètre non résistif ;
un convertisseur analogique-numérique (730) convertissant le signal amplifié en un signal numérique ;
un filtre de signal (740) filtrant le signal numérique converti ; et
une unité de communication de données (750) transmettant le signal filtré.

2. Capteur pour la surveillance de corrosion selon la revendication 1, dans lequel la partie de film de revêtement (110) de l'échantillon de film de revêtement est formée sur une surface d'une partie de corps (120) formée du même matériau que le matériau constituant la structure.

3. Capteur pour la surveillance de corrosion selon la revendication 1 ou 2, dans lequel des fils de raccordement de signal (440) sont connectés respectivement à l'échantillon de film de revêtement (100), à l'échantillon d'anode sacrificielle (200) et à l'électrode de référence (300).

4. Capteur pour la surveillance de la corrosion selon la revendication 3, **caractérisé en ce que** les fils de raccordement de signal sont raccordés électriquement à l'unité de traitement de signal.

5. Capteur pour la surveillance de la corrosion selon la revendication 4, le boîtier de capteur étant pourvu d'un couvercle (630) pour la maintenance de l'unité de traitement de signal.
